Europäisches Patentamt

European Patent Office

Office européen des brevets

(11) Publication number : **0 620 647 A2**

(12) **EUROPEAN PATENT APPLICATION**

(21) Application number : **94302630.2**

(22) Date of filing : **13.04.94**

(51) Int. Cl.⁵ : **H03K 17/95**

(30) Priority : **14.04.93 US 46614**

(43) Date of publication of application :
**19.10.94 Bulletin 94/42**

(84) Designated Contracting States :
**DE FR GB**

(71) Applicant : **NAMCO CONTROLS
CORPORATION
7567 Tyler Boulevard
Mentor, Ohio 44060 (US)**

(72) Inventor : **Plott, Robert J.
7637 Acacia Avenue
Mentor, Ohio 44060 (US)**
Inventor : **Crosby, Robert J.
1666 Mapledale Road
Wickliffe, Ohio 44092 (US)**

(74) Representative : **Skinner, Michael Paul
c/o Swindell & Pearson
48 Friar Gate
Derby DE1 1GY (GB)**

(54) **Magnetically activated proximity switch.**

(57)    A control circuit (120) including a Hall sensor (124) for monitoring the position and movement of a magnetic coupled to an actuator piston. The piston is typically part of a pneumatically actuated cylinder used to perform a manufacturing step. The Hall sensor is periodically powered up by a sensor clock at a sufficient voltage to cause the Hall sensor to make a magnetic field evaluation. The sensor clock then powers down the Hall sensor causing an output from the Hall sensor to be captured by a logic cirucit (126). The logic circuit, in turn, activates a switch (122) used to activate or de-activate a load (100).

FIG. 2

The present invention concerns a proximity switch for monitoring position of a magnetic or ferrous actuator such as a pneumatically actuated cylinder. Prior art pneumatic cylinders include a magnet, carried by a cylinder piston, which allows movement of the piston to be monitored. A sensing probe monitors the piston and provides an indication when the piston is fully retracted or fully extended. An output from the sensor can then be used to control other manufacturing operations or processes. As an example, the output from the sensor could be used to co-ordinate two processing steps where a first step is performed by the pneumatic cylinder piston and a second step is coordinated to occur after the cylinder actuation.

U.S. Patent No. 4,571,501 to Crosby which issued February 18, 1986, concerns an electronic control circuit that is coupled in series with a load circuit for controllably actuating the load circuit. The load can, for example, constitute a drive motor or actuator which performs manufacturing processes. One use of the circuitry disclosed in the '501 patent is for use with a proximity switch. When the proximity switch detects the presence of an object, the switch opens and the electronic control circuit is forced into a regeneration mode. This effectively short-circuits the control circuit and applies power to a load circuit. One aspect of the '501 disclosure concerns the fact that the control circuit has only two wires in series with the load.

U.S. Patent No. 4,994,738 to Soyck et al. which issued February 19, 1991, concerns an inductive proximity switch that uses a high-frequency oscillator, an oscillator coil, and analyzing circuit to detect inclination of a proximity switch. A circuit core is constructed of ferrite having a thin section with high permeability (common to internal and external magnetic fields) and includes a yoke body surrounded by the core. As the magnetic field in the vicinity of the highly permeable thin section changes, this change can be detected and used to change a switch output.

Proximity switches have been used in conjunction with pneumatically actuated cylinders. Use of magnets that move with an actuator piston have enabled proximity switches which sense magnetic fields to be used as "through the wall" sensors to monitor cylinder position. It is believed prior art sensors utilize technology similar to that disclosed in the '738 patent to Soyck et al. Proximity sensors utilizing a wire coil surrounded by a magnetic core structure are mounted to the cylinder wall and can monitor position of the magnet attached to the cylinder piston.

The invention provides control apparatus for monitoring a position of an actuator that carries a magnetic member, said control apparatus comprising:

a) magnetic field sensing means positioned along a travel path of said actuator and having a power input and an output for providing a sensor output signal in response to magnetic fields affected by a magnetic member in a sensing region of the magnetic field sensing means;

b) logic means for receiving the output signal from the magnetic field sensing means and providing a logic means output;

c) timing means for periodically energizing the power supply input of the magnetic field sensing means to cause the magnetic field sensing means to periodically monitor a magnetic field; and

d) switching means coupled to the logic means output to actuate a load by providing a low impedance current path through said load in response to an output from the magnetic field sensing means.

Apparatus constructed in accordance with the present invention is particularly suited for monitoring position of a magnetic or ferrous member. A magnetic field switch positioned along a travel path of the magnetic member preferably includes a power supply, a timer and latch circuit, and a magnetic field sensor for providing a response to magnetic fields in a sensing region. A logic circuit preferably conditions output signals from the magnetic field sensor and presents an input to the latch circuit.

The timer may periodically energize the power supply input of the magnetic field sensor, enabling the magnetic field sensor, when powered, to monitor a magnetic field. A switch coupled to the logic circuit may actuate a load by providing a low impedance current path through the magnetic field switch in response to the conditioned output from the magnetic field sensor.

A preferred magnetic field sensor includes a Hall effect device for monitoring magnetic field strength. The Hall effect device requires a minimum amount of power to obtain a magnetic field reading. By cycling power to the Hall device on and off, the timer circuit may provide adequate power to the Hall device but reduce the average current draw from a typical value of 10 to 25 ma/sensor to a value of less that 0.5ma. This makes the Hall effect sensor circuitry compatible with standard two-wire switches which typically operate on 1.7ma in the off state.

Control apparatus constructed in accordance with a preferred embodiment of the invention includes two spaced apart Hall sensors each having at least two sensor outputs. The logic circuit may evaluate the two Hall sensor outputs and accurately signals the presence of an actuator magnet.

The apparatus may also include magnetic field focusing members positioned relative to the magnetic field sensor to shape the magnetic field in the sensing region of the magnetic field sensor.

In accordance with a preferred embodiment of the invention, the logic circuit comprises memory means

2

for storing an output from the magnetic field sensor each time the timing circuit energizes the magnetic field sensor. The timing circuit most preferably comprises a rectangular wave signal generator that powers a Hall sensor on a leading edge output and latches onto an output from the Hall sensor on a trailing edge of the Hall sensor energization pulse.

Commercially available Hall effect sensors can include a voltage regulator, Hall sensor element, amplifier, comparator and output stage integrated into one low-cost package. This type device provides a digital output which is either ON or OFF depending on the magnetic flux level. Built-in hysteresis actively modifies the switching threshold to create separate ON and OFF points so that the output will switch cleanly. Periodic powering of the Hall sensor defeats the built-in hysteresis function integrated into the Hall sensor. A lack of hysteresis can cause output instability when the magnetic field is near the switch threshold.

The Hall device requires a finite amount of time after power-up to stabilize its sensitivity. During this power-up time the ON and OFF thresholds increase until reaching final fixed levels. Hence, the sensitivity during the power-up period is time dependent. If the flux level detected by the sensor exceeds the thresholds at any point or points during the power-up period, the output will switch accordingly. By monitoring the Hall sensor output during this power-up time, information about the strength of the applied magnetic field can be gathered. Varying the point in time when the output is monitored effectively varies the sensitivily of the Hall sensor.

To create hysteresis around the switching threshold, the output state of the Hall sensor is preferably latched into memory at the end of each cycle. The state stored in memory may be used to vary the width of the pulse signal used to power the Hall sensor during the next cycle, controlling the Hall sensor's threshold with a small mount of positive feedback, thereby avoiding undesirable output instability when operating near the switching threshold.

Preferably the magnetic field sensing means comprises a ferrite pot core supporting a conductor winding electrically connected to the timing means, a planar surface of said pot core facing toward said magnetic member, and an open end of said pot core facing away from magnetic member.

The invention also provides a method for monitoring the position of a moveable actuator piston that carries a magnetic member comprising the steps of:

positioning of a magnetic field sensor along a travel path for the moveable actuator piston;

providing a clock signal having an on/off duty cycle;

coupling the clock signal to a power input of the magnetic field sensor to sense a magnetic field during an on portion of the duty cycle;

latching an output from the magnetic field sensor on a trailing edge of the clock signal on cycle; and

providing an output signal corresponding to the sensor output.

Embodiments of the present invention, and their method of operation, will now be described in more detail, by way of example only and with reference to the accompanying drawings, in which:

Figure 1 is a perspective view showing a magnetic field switch positioned for through-the-wall sensing of a magnet that moves back and forth through a cylindrical actuator;

Figure 2 is a schematic diagram of a circuit that includes a Hall effect sensor for monitoring a position of a magnet;

Figures 3A and 3B are logic, power and output circuitry for monitoring a position of a magnet;

Figure 4 is a schematic of a circuit connected to a pot core sensor used in monitoring a position of a magnet;

Figure 5 is a perspective view of a sensor used in conjunction with the Figure 4 circuit;

Figure 5A is a section view of the Figure 5 sensor;

Figure 6 is a schematic side view of an actuator cylinder and magnet carried by an actuator piston;

Figure 7 is a perspective view showing a sensor printed circuit board for mounting two Hall sensors in relation to an actuator cylinder;

Figure 8 is an enlarge side view of the Figure 7 circuit board arrangement;

Figure 9 is a plan view of the Figure 7 circuit board arrangement; and

Figures 10A and 10B are timing diagrams showing outputs from a Hall sensor for different magnetic field strengths and a Hall device energization scheme to provide hysteresis for a Hall device sensor that is operated in a pulsed mode.

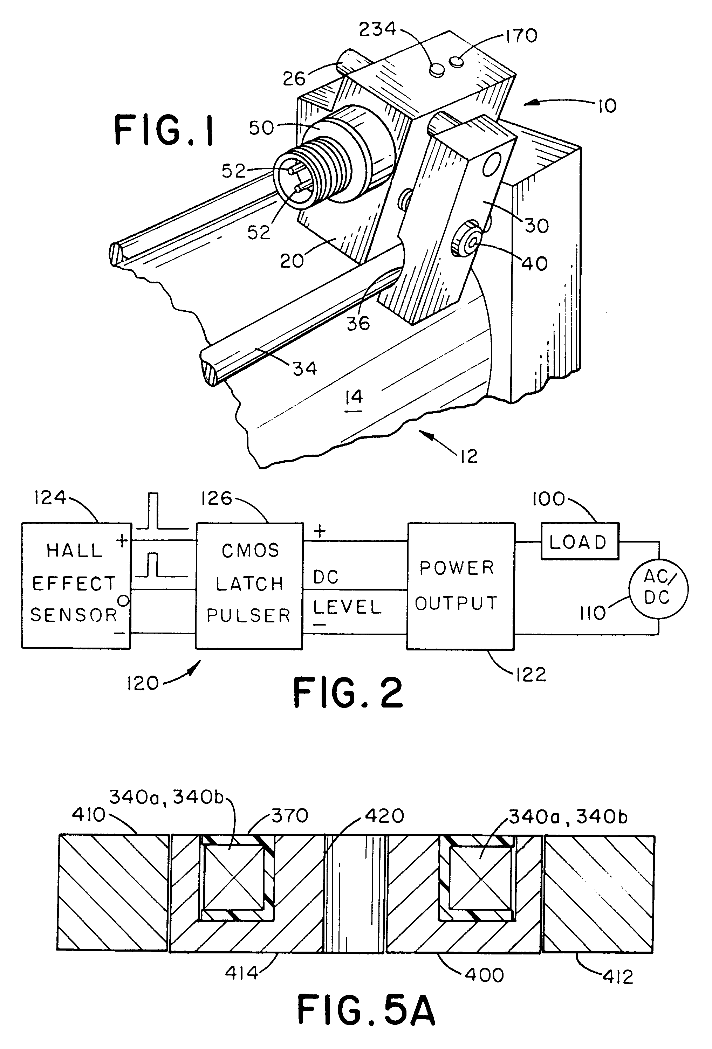

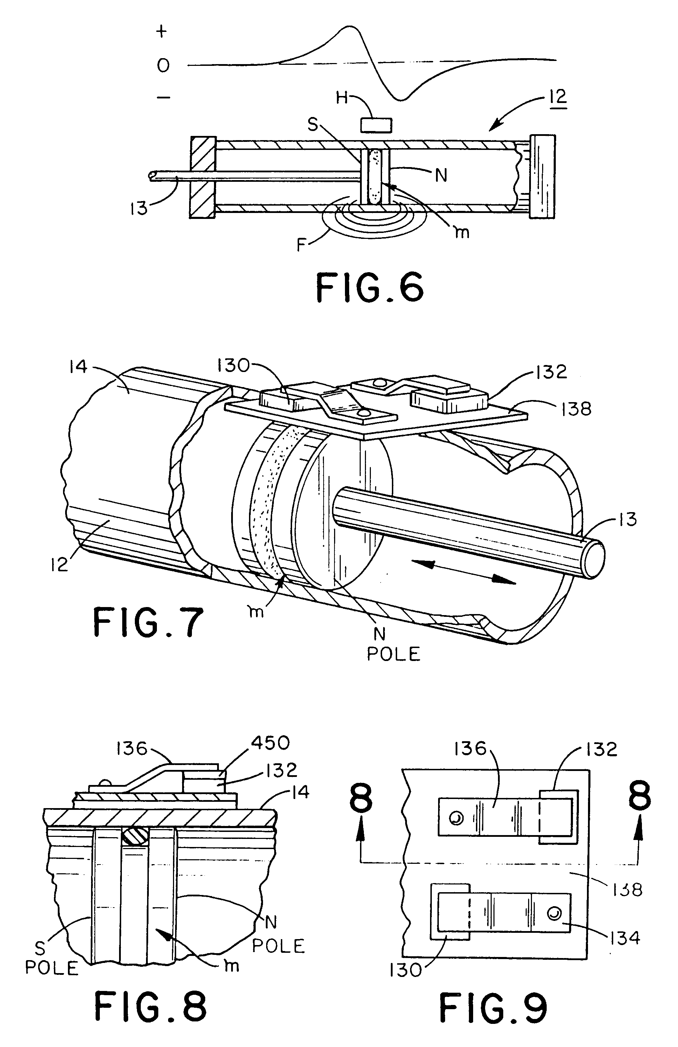

Figure 1 is a perspective view showing a switch 10 mounted relative to a pneumatically actuated cylinder 12 having a piston 13 (Figure 7) that is extended and retracted during performance of a manufacturing step. The cylinder piston 13 (Figure 7) carries a magnet M (Figure 7) so that as the cylinder is actuated, the magnet moves back and forth through a cylinder housing 14. As the magnet moves relative to the housing 14, magnetic fields that extend through the cylinder housing 14 change in intensity and direction. The switch 10 monitors these changes and produces an output signal when the magnet reaches a predetermined position and, therefore, the switch is referred to as a magnetic field switch.

The switch 10 is classified in the group of through-the-wall sensors. The switch 10 is, therefore, non-invasive and requires no modification to the construction of the cylinder 12. The switch 10 can be used in conjunction with a variety of cylinders and can be adapted for use in other magnetic field sensing requirements.

The switch 10 includes a housing 20 which supports one or more Hall effect devices. Electronic circuitry for energizing the Hall effect devices as well as monitoring output signals from those devices is also contained within the housing 20. To mount the switch 10 to the cylinder, a rod-like extension 26 that extends perpendicularly away from a mounting block 30 is pushed into a through passage in the housing 20 and then the housing 20 and mounting block are pushed together until both the housing and mounting block engage a rod 34 supported by the cylinder 12. A slot 36 on one side of the mounting block 30 engages the rod 34. By tightening down an Allen head screw 40 which extends through the mounting block 30 into a threaded opening on the housing, the rod 34 is trapped between the mounting block 30 and the switch housing 20. To remove the sensor 10 from the cylinder 12, the Allen head screw 40 is loosened enough to allow the rail 34 to slip through a widened gap between the mounting block 30 and the sensor housing 20.

Electrical signals are routed into the switch housing 20 by means of an electrical connector 50 or other suitable cable assembly. Once the switch housing 20 has been placed or positioned with respect to the cylinder 12, a female connector (not shown) having connector contacts coupled to a load is mated with the electrical connector 50 causing the female contacts to engage male pins 52 of the connector 50. Electrical signals pass through the connector 50 to the female connector and are routed from the switch 10 by means of flexible cabling. As described below, the cabling leads to a power supply and an external load which is actuated by the switch 10.

Figure 2 is a block diagram showing circuit components for sensing position of the cylinder piston. As noted previously, external to the housing 20 is most typically a load 100 and an AC or DC power source 110. In response to sensing of the magnetic field caused by movement of the magnet within the cylinder 12, a circuit 120 supported within the sensor housing 20 changes state to cause the load 100 to be energized or activated by the power source 110. The circuit 120 includes a power output portion 122 for providing a low impedance electrical path in response to sensing of a magnetic field. The power output portion 122 most typically includes a switch which, when actuated, provides a low impedance signal path, allowing the AC or DC power supply 110 to activate a load 100. The load may comprise a motor, actuator, transmitter, or other device which is required to respond to position of a piston within the cylinder 12.

One or more Hall devices and logic circuitry for evaluating outputs from the Hall devices are depicted schematically by a Hall effect sensor circuit 124. As described below, the use of multiple Hall sensors provides greater accuracy in monitoring magnetic fields produced by the movable magnet M (Figure 7) within the cylinder. Intermediate the power output circuit 122 and the Hall effect circuit 124 is a latch/pulser circuit 126. The circuit 126 provides pulses for energizing the Hall effect sensor circuit 124 at a pulse rate and of a pulse magnitude to energize the Hall effect sensor circuit 124 while limiting the power consumption of the coinbination of Hall effect sensor circuit 124, intermediate circuit 126 and power output circuit 122.

Figures 6-9 schematically depict a pneumatically actuated cylinder 12 showing an internal piston 13 carrying a magnet M. A region inside the cylinder on one side of the magnet is pressurized and depressurized to extend and retract the piston 13. As the piston is extended and retracted, the magnet M moves back and forth through the cylindrical housing 14 and causes magnetic flux lines F which extend through the cylinder housing 14 to vary in magnitude and direction.

Figure 6 graphically depicts a change in magnetic field F sensed by one Hall sensor H as the magnet M in Figure 6 moves relative to the Hall sensor. When the Hall sensor H is coincident with the magnetic center position of the magnet, the Hall sensor output changes state. The Hall sensor switches based upon the direction and level of flux through the Hall sensor determined by the relative position of the north and south pole flux-emitting surfaces N, S of the magnet. When a Hall device sensing surface intercepts lines of flux closest to the south pole, a first polarity signal is output from the Hall sensor. When the lines of flux intercepting the Hall device sensing surface are predominantly from the north pole, this polarity changes. By using two Hall sensing devices 130, 132 (Figure 7) and monitoring the outputs from those Hall devices for an opposite polarity signal, a center region approximately coaxial with a region midway between the magnet M poles (NORTH and SOUTH) is accurately determined. If both Hall sensing devices 130, 132 are located primarily within flux lines emanating from one or the other of the magnetic poles, each will produce the same polarity output and the two Hall devices are not aligned with the axial position of the magnet.

To enhance the magnetic field sensing capabilities of the two Hall devices 130, 132, two magnetic field concentrators 134, 136 are mounted to a printed circuit board 138 that also supports the Hall devices 130, 132 and pulser latch and Hall circuits 124, 126. The field concentrators 134, 136 overlie the Hall devices and concentrate magnetic flux through the magnetic field sensing surfaces of the Hall devices. These field sensing surfaces are generally parallel to the cylinder wall 14 in Figures 6 and 7. The magnetic field concentrators 134, 136 are most preferably constructed from a ferro-magnetic band having a width approximately the same as the field sensing surface of the Hall devices and of a length sufficient to allow the concentrators to span the width of the magnet.

Pulsed activation of the Hall effect sensor circuit 124 lowers the power needed to energize the Hall effect sensor circuit 124 while reliably sensing the presence of the movable magnet within the cylinder. As the pulse is applied to the Hall sensor circuit 124, an output pulse based upon the Hall sensor circuit is latched into the latch/pulser circuit 126. Stated another way, each time the Hall effect sensor circuit 124 is activated to sense the magnetic field strength in the vicinity of the switch 10, the same energization pulse is used to capture the data output from the one or more Hall sensors.

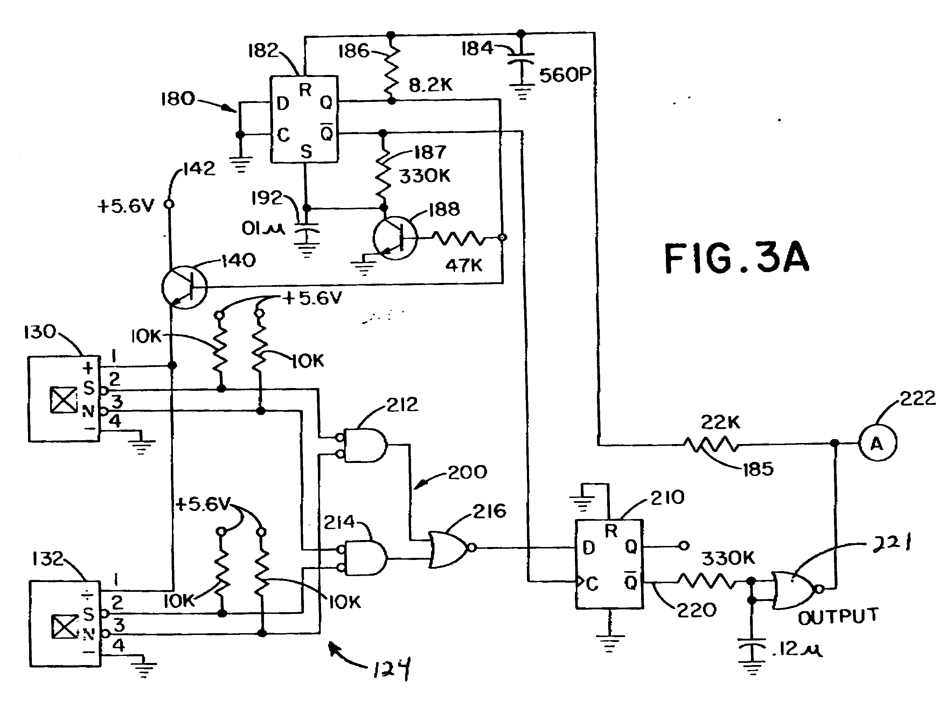

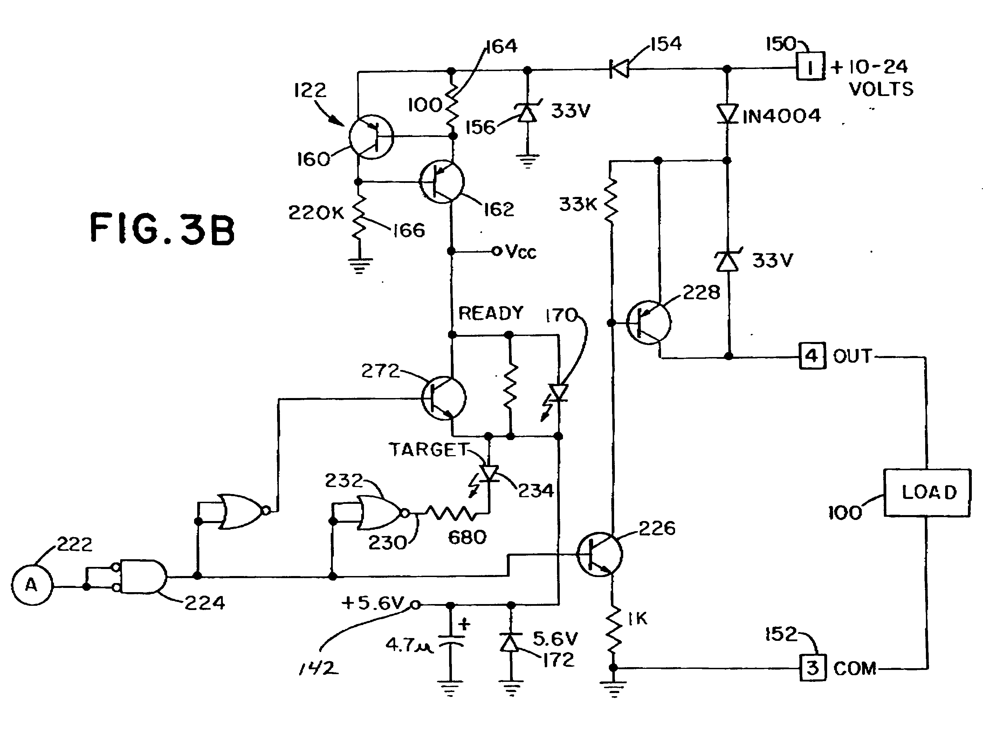

Figures 3A and 3B are detailed schematics of the power output circuit 122, Hall effect sensor circuit 124, and latch/pulser circuit 126. The Hall effect sensor circuit 124 includes two Hall devices 130, 132 spaced apart and configured for accurate sensing of magnetic field strength in the vicinity of the sensor. The Hall devices 130, 132 are mounted within the switch housing 20 in a position such that the active magnetic field sensing surfaces of these two sensors face toward the cylinder surface 14.

The preferred Hall devices are commercially available from Allegro Micro Systems Inc. as Part No. UGN 3235 and include four input/output pins which have been labeled 1-4 in Figure 3A. A first pin, also designated with a "+", receives a power signal to activate the Hall device. A bottom pin designated with a "-" is grounded or maintained at a referenced potential. The Hall device is capable of producing an output signal in response to static or changing magnetic fields whenever the + input at pin 1 is 4.5 volts greater than the reference or ground signal at pin 4.

Power signals are applied in unison to the two Hall sensors 130, 132 of Figure 3A by activation of a switching transistor 140. When this transistor turns on, a power pulse is applied from a 5.6-volt junction 142 to power up the Hall devices 130, 132. The 5.6-volt signal at the junction is supplied to the latch/pulser circuit 126 by the power output circuit 122 which is depicted in Figure 3B.

Turning to Figure 3B, the circuit 122 includes a power input 150 carrying a signal of approximately 10 to 24 volts and also includes a grounded input 152. Energization signals from the input 150 pass through a reverse polarity protection diode 154. An over voltage protection zener diode 156 limits the input voltage to 33 volts. When the signal at the input 150 is applied to the circuit, two current-limiting transistors 160, 162 are rendered conductive due to the biasing action of two resistors 164, 166. When the transistor 162 turns on, current flows through the resistor 164 turning on transistor 160 which controls the base of transistor 162 defining a constant current source of approximately 6 milliamps. This transistor turn on also activates a light-emitting diode 170 and causes a voltage-limiting zener diode 172 to break down and provide the 5.6-volt signal to the junction 142 shown in Figure 3A. As seen in Figure 1, the light-emitting diode 170 is mounted in a position to be visible from the housing exterior, providing a visual indication that the magnetic switch is ready to sense. A collector junction of the transistor 162 is also used to provide a regulated VCC signal for powering the logic circuits (described below) that monitor output from the Hall effect devices 130, 132.

Returning to Figure 3A, an oscillator circuit 180 includes an R-S flip-flop 182 and two resistor/capacitor circuits external to the R-S flip-flop for causing the Q (and Qbar) output to be turned on and off at a regular frequency and with controlled ON and OFF times. A pulse signal at the Q output of the flip-flop 182 turns on and off the transistor 140, thereby periodically energizing the Hall effect devices 130, 132.

A preferred duty cycle of the oscillator 180 is approximately 1%. The ON time (Q output high) is primarily controlled by a resistor 186 and a capacitor 184 and is secondarily influenced by a resistor 185. This ON time is nominally set to about 6 microseconds. The OFF time (Qbar output high) is controlled by a resistor 187 and capacitor 192. When the Q output is high, the capacitor 184 charges through the resistor 186. When the voltage on the capacitor 184 rises to a certain level, the R input of the RS flip-flop resets the Q output to a low level and the Q bar output to a high level. The Q bar output charges the capacitor 192 through the resistor 187 and provides a rising clock edge required to latch the output state of a logic circuit 200 into memory. When the voltage on the capacitor 192 reaches a certain level, the S input of the RS flip-flop sets the Q output to a high level turning on transistors 140 and 188. The transistor 188 rapidly discharges the capacitor 192 to ensure it is fully discharged before its next charge cycle begins.

The logic circuit 200 shown in Figure 3A is coupled to outputs from the Hall devices 130, 132 and evaluates the signal output from those devices and signals the D input to a flip-flop 210. Each of two AND gates 212, 214 are connected to opposite polarity outputs, one from each of the two Hall sensors. Since the Hall sensors are spaced apart by a distance approximating the length of the magnet M, the two sensors will be exposed to opposite magnetic fields only when the magnet is centered between them. The two AND gate signals are connected to D-latch 210 through a NOR gate 216 such that a true output from either AND gate will present a low level to the D-latch 210.

Because one AND gate signals an N-S magnet orientation and the other AND gate signals a S-N magnet orientation, the OR gate function allows equal operation regardless of the absolute polarity of the magnet and/or the sensor mounting direction.

The state present at the D input of 210 is latched on the rising edge of the signal on the C input. Since this signal is derived from the Q bar output of the flip-flop 182, it is coincident with the end of the Hall sensor energization pulse. Thus, the oscillator circuit 180 both powers the two Hall effect devices 130, 132 and causes the flip-flop 210 to capture an output signal indicative of the magnetic field strength at the trailing edge of the oscillator signal. When the oscillator output drops low, the D input to the flip-flop 210 is latched into the flip-flop and presented as an output at the flip-flop's Q bar output 220. The output from the flip-flop 210 as a function of the SN outputs from the Hall effect devices is charted below in Table 1:

## TABLE 1

| Hall 1 | | Hall 2 | | D-latch |
|---|---|---|---|---|
| S | N | S | N | Output (Qbar) |
| OFF | OFF | OFF | OFF | OFF |
| OFF | OFF | OFF | ON | OFF |
| OFF | OFF | ON | OFF | OFF |
| OFF | ON | OFF | OFF | OFF |
| OFF | ON | OFF | ON | OFF |
| OFF | ON | ON | OFF | ON |
| ON | OFF | OFF | ON | ON |
| ON | OFF | ON | OFF | OFF |
| ON | OFF | OFF | OFF | OFF |

Note: A magnetic field cannot be both N and S simultaneously, therefore both outputs from a single Hall device cannot be ON simultaneously.

The output of the flip-flop 210 is buffered by an invertor 221 before being presented to a junction 222. The resistor 185 provides a feedback path that modifies the pulse width of the flip-flop 182 depending on the state of junction 222 in order to provide hysteresis to the switch operation.

When the junction 222 is HIGH, the capacitor 184 coupled to the R input of the flip-flop 182 charges more quickly due to the parallel charging path created by the resistor 185. This shortens the time duration of the energization pulse applied to the Hall sensors and does not allow enough time for them to reach their final sensitivity. If, at the end of this reduced sensitivity period, there is sufficient flux of different polarities to turn ON the outputs from the respective Hall sensors, the output of the logic circuit 200 switches to LOW and this level is stored in the D-latch 210 by the rising edge signal on the clock input. The level at junction 222 switches high when a proper magnetic field is present at the face of the sensor 10 corresponding to the presence of the magnet. When the junction 222 is LOW, the capacitor 184 charges at a slower rate due to the shunting effect of the resistor 185.

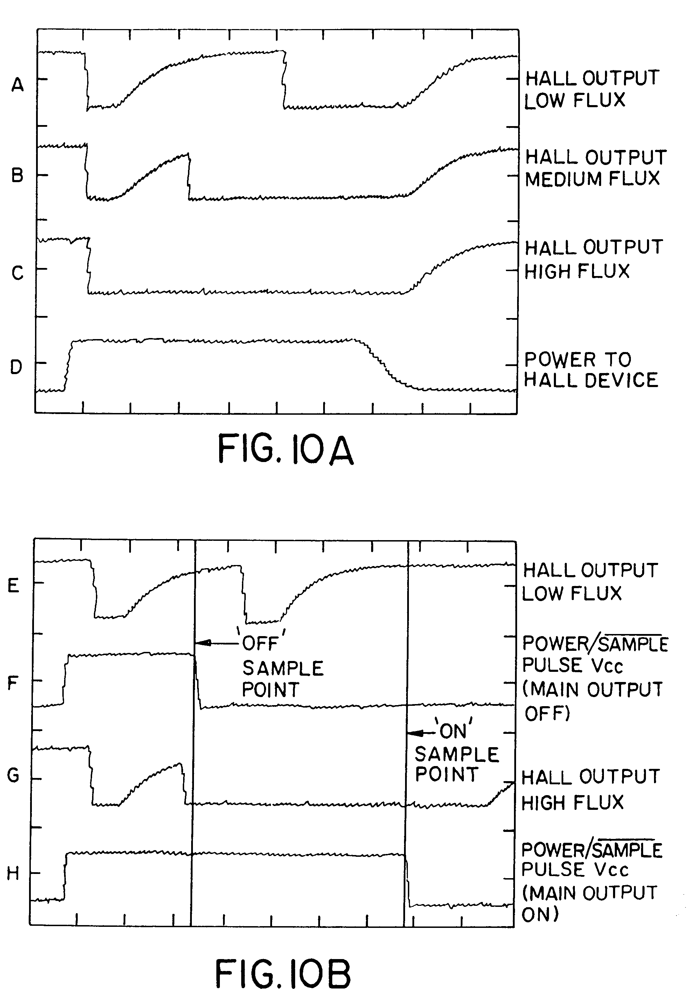

Increasing levels of magnetic flux cause the output to reliably switch low earlier in the Hall device power cycle. By sampling the output at different times after application of the oscillator power pulse, differences in magnitudes of flux can be discerned. This is seen from traces A-C of Figure 10 which correspond to the Hall device output for low, medium and high flux density.

In application, when the main output of a switching transistor 228 is off, the Hall sensor output is sampled about 3μs after the power pulse (see trace F Figure 10). If the Hall output is low at the sample point, the transistor 228 is turned "on" and the sample point time is shifted to approximately 6μS (see Traces G & H). This adjustable sampling of the Hall output provides hysteresis by detecting the response time differences between low and high levels of magnetic flux.

The level at junction A 222 connects to an AND gate 224 whose output is connected to the base input of a switching transistor 226. Turn-on of this transistor 226 pulls the base input of the switching transistor 228 low enough to cause the transistor 228 to conduct. This is the switch which activates the load circuit 100 in response to sensing of a magnetic field by the Hall effect devices 130, 132. In addition to turning on the transistor 226, a high output from the AND gate 222 causes an output 230 from an OR gate 232 to go low, activating a second light-emitting diode 234, indicating a target is located between the two Hall effect devices 130, 132. The target-indicating light-emitting diode 234 is located next to the READY light-emitting diode 170 on the outwardly facing surface 24 of the switch housing 20.

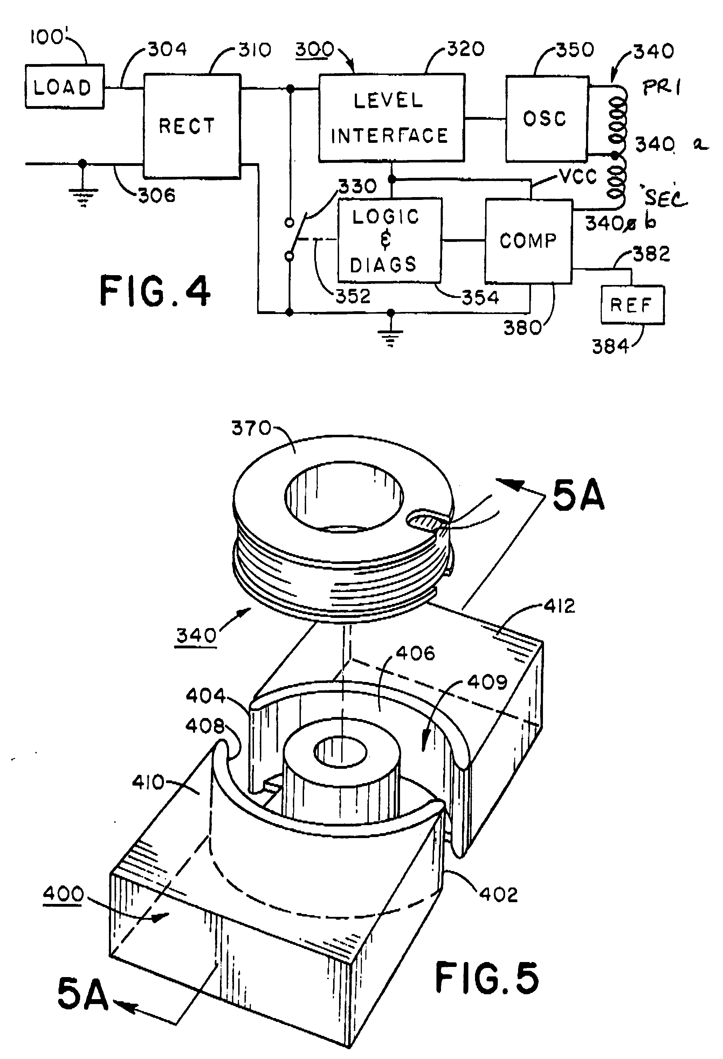

Figures 4 and 5 show an alternate circuit 300 and sensor arrangement 302 for monitoring field strength. Two conductors 304,306 couple an AC or DC signal to a full-wave rectifier bridge circuit 310 that converts the AC or DC signal through a load 100' into a DC signal which is applied to a level interface circuit 320 in Figure 4.

The circuit 320 is described in issued U.S. patent to Crosby number 4,571,501 which is incorporated herein by reference. The circuit 320 interfaces higher level voltages from the bridge circuit 310 with the relatively low-level voltages of the CMOS logic circuits in Figure 4. When power is applied to the two inputs to the full-wave rectifier circuit 310, a transistor in the interface 320 conducts at 1.5 ma typical constant current, causing a zener diode to break down providing a 5.6-volt reference signal for energizing the CMOS circuit components in Figure 4. This circuit 310 could also be used to interface with the circuit of Figures 3A and 3B. Thus, the version of the magnetic field sensing switch that utilizes a Hall sensor can interface with the load via two wires instead of the three shown in Figure 3B.

A switch 330, most preferably constructed utilizing a switching transistor, opens and closes in response to magnetic fields sensed by a sensing coil 340 coupled to an oscillating circuit 350. An input 352 from a logic and diagnostic circuit 354 opens and closes the switch 330, creating a high or low impedance path in series with the load circuit 100 .

The oscillator circuit 350 activates a primary coil 340a at an oscillator frequency to energize the primary 340a with an alternating current signal which, in turn, induces a signal in a coil secondary 340b. In accordance with the preferred embodiment of the invention, the primary and secondary coils 340a, 340b are coaxially wound about a common axis on a bobbin 370 which is supported within a pot core 400 (see Figure 5). The combination of pot core 400 and bobbin 370 are supported in relation to the cylindrical surface of an actuator cylinder so that as the magnetic field varies in the vicinity of the cylinder due to actuation of the piston, this field passes through a flux path common to the primary and secondary coils 340a, 340b. As is known in the prior art, the presence of the magnetic field disrupts the resonant frequency of the oscillator circuit 350 causing the signal output from the transformer secondary 340b to change. This changing signal from the secondary 340b is monitored by a comparator circuit 380 coupled to an output from the secondary 340b.

The comparator circuit 380 includes a reference input 382 derived from a reference signal generator 384. When the input from the secondary 340b corresponding to the signal induced in the secondary falls below the reference signal input 382 from the reference generator 384, the comparator output changes state and this change of state is monitored by the logic and diagnostic circuit 354. The logic and diagnostic circuit 354, in turn, generates an output to control the state of the switch 330.

Turning now to Figures 5 and 5A, the pot core 400 is a commercially available device used primarily for high frequency transformer applications wherein coil windings are supported within a magnetically permeable material to enhance the magnetic field transmissive characteristics of the transformer. The pot core 400 disclosed in Figure 5 is commercially available from Siemens, Stackpole, or Phillips. It is constructed from a ferrite material and includes two notches 402, 404 extending along opposite edges of generally cylindrical wall surfaces 406, 408. The bobbin 370 is sized to fit within an annular cavity 409 defined by the pot core 400 so that the primary and secondary windings of the bobbin are substantially enclosed by ferrite material.

Located on opposite sides of the pot core 400 in abutting relationship with the cylindrical wall surfaces 406, 408 of said pot core, leaving slots 402, 404 exposed, are two field concentrators 410, 412. The two field concentrators are also constructed of a ferrite material and are oblong in shape having a width approximately the same as the diameter of the pot core 400. The field concentrators help focus the magnetic flux from the magnet as the piston inside the cylinder moves back and forth in its travel path. As an alternative to the use of solid oblong concentrators 410, 412, two additional pot cores not containing bobbins or coils could be positioned in side-by-side abutting relation to the pot core 400 shown in Figure 5. In either embodiment, however, the pot core coil and field concentrators are then potted within a suitable encapsulating material and mounted within a housing 20 such as the housing depicted in Figure 1.

As seen in the section view of Figure 5A, a pot core surface 414 facing away from the annular opening 409 in the pot core 400 is planar, except in the region of a through passageway 420 which extends completely through the pot core 400. This through passageway is typically needed to allow the pot core to be mounted when used to construct a transformer. When potted within the housing 20, the planar pot core surface 414 faces the outer surface 14 of the cylinder 12. It is not grooved or machined so that a commercially available pot core can be used to fabricate the sensor illustrated in Figure 5.

The present invention has been described with a degree of particularity, but modifications to the disclosed design fall within the scope of the invention. As an example, although two Hall sensors are disclosed in the preferred embodiment of the invention, a single Hall device having its principle magnetic field sensing face directed perpendicularly to the travel path of the magnet could be used to monitor the position of the magnet. Pulsed actuation of the single Hall device is utilized and hysteresis creation by varying the length of the pulse is also incorporated. An additional alternate embodiment contemplates the use of a magnet M 450 (Figure 8) next to or in contact with the Hall device or devices on the circuit board 138. In this application, the sensor 10 would be used for monitoring the position of a ferro-magnetic material. When the ferro-magnetic material comes into close proximity to the magnet M 450 and one or more Hall effect devices, the field modification due to the presence of the ferro-magnetic material causes the Hall device to interpret the magnetic field variation as caused by the material and, therefore, produce a signal output. For the foregoing reasons, it is appreciated that the invention is to include all modifications and alterations from the disclosed design falling within the spirit or scope of the appended claims. Although the preferred embodiment describes a digital output Hall effect sensor, it is under-stood that this invention could also be implemented using an analog output Hall sensor and appropriate signal conditioning circuitry.

Whilst endeavouring in the foregoing Specification to draw attention to those features of the invention believed to be of particular importance it should be understood that the Applicant claims protection in respect of any patentable feature or combination of features hereinbefore referred to and/or shown in the drawinqs whether or not particular emphasis has been placed thereon.

## Claims

1. Control apparatus for monitoring a position of an actuator that carries a magnetic member, characterised by comprising:

    a) magnetic field sensing means positioned along a travel path of said actuator and having a power input and an output for providing a sensor output signal in response to magnetic fields affected by a magnetic member in a sensing region of the magnetic field sensing means;

    b) logic means for receiving the output signal from the magnetic field sensing means and providing a logic means output;

    c) timing means for periodically energizing the power supply input of the magnetic field sensing means to cause the magnetic field sensing means to periodically monitor a magnetic field; and

    d) switching means coupled to the logic means output to actuate a load by providing a low impedance current path through said load in response to an output from the magnetic field sensing means.

2. Control apparatus according to Claim 1, further characterised by at least two spaced apart magnetic field sensors having at least two sensor outputs and wherein the logic means comprises means for evaluating said at least two sensor outputs.

3. Control apparatus according to Claim 1 or 2, further characterised by magnetic field focusing means positioned relative to the or at least one magnetic field sensor to shape the magnetic field in the sensing region of said one or more magnetic field sensors.

4. Control apparatus according to Claim 3, characterised in that the magnetic field focusing means comprises a permanent magnet and the magnetic member whose position is monitored comprises a ferromagnetic member.

5. Control apparatus according to any preceding Claim, characterised in that the logic means comprises memory means for storing an output from the magnetic field sensor each time the timing means energizes the magnetic field sensor.

6. Control apparatus according to any preceding Claim, characterised in that the or at least one magnetic field sensing means comprises a Hall device and the timing means comprises means to adjust a pulse width of a signal coupled to the power supply input to provide a hysteresis to a response of said magnetic field sensing means.

7. Control apparatus according to any preceding Claim, characterised by additionally comprising power supply means for energizing the timing means, said power supply means comprising means that draw a reduced average current from lines passing to the load due to the periodic energization of the field sensing means by said timing means.

8. Control apparatus according to any preceding Claim, characterised in that the power supply means is connected to the load by means of only two conductors.

9. A method for monitoring the position of a moveable actuator piston that carries a magnetic member, characterised by the steps of:

positioning of a magnetic field sensor along a travel path for the moveable actuator piston;

providing a clock signal having an on/off duty cycle;

coupling the clock signal to a power input of the magnetic field sensor to sense a magnetic field during an on portion of the duty cycle;

latching an output from the magnetic field sensor on a trailing edge of the clock signal on cycle; and

providing an output signal corresponding to the sensor output.

10. A method according to Claim 9, characterised in that the positioning step is performed by mounting a hall effect device next to the travel path.

11. A method according to Claim 9 or 10, characterised in that the on/off duty cycle is chosen to maintain an average current draw to the magnetic field sensor below a threshold while providing adequate power to the magnetic field sensor.

12. A method according to Claim 9, 10 or 11, characterised in that an on portion of the on/off duty cycle is adjusted to control sensitivity of the magnetic field sensor.

13. Control apparatus according to any of Claims 1 to 8, characterised by said magnetic field sensing means comprising a ferrite pot core supporting a conductor winding electrically connected to the timing means, a planar surface of said pot core facing toward said magnetic member, and an open end of said pot core facing away from magnetic member.

14. Control apparatus according to Claim 13, further characterised by comprising one or more magnetic field concentrators.

15. Control apparatus according to Claim 14, characterised in that the one or more magnetic field concentrators are constructed of a ferrite material.

16. Control apparatus according to Claim 14 or 15, characterised in that the one or more magnetic field concentrators comprise permanent magnets and the magnetic member whose position is monitored comprises a ferro-magnetic member.

FIG. 1

234

170

26

50

52

52

10

30

40

20

36

34

14

12

---

124

126

100

| HALL EFFECT SENSOR | CMOS LATCH PULSER | POWER OUTPUT | LOAD |

+ 
—

+ 
DC
LEVEL
—

AC/DC

110

120

122

FIG. 2

---

340a, 340b

410

370

420

340a, 340b

414

400

412

FIG. 5A

10

FIG.3A

FIG.3B

EP 0 620 647 A2

EP 0 620 647 A2

FIG.4

FIG.5

13

FIG.6

FIG.7

FIG.8

FIG.9

FIG. IO A

FIG. IOB